# EUROPEAN PATENT SPECIFICATION

(11) **EP 0 284 438 B1**
(45) Date of publication and mention of the grant of the patent: **30.05.2001**
(21) Application number: 88302733.6
(22) Date of filing: 28.03.1988
(51) Int. Cl.: H01L 39/12, H01L 39/24

(54) **Superconducting materials and methods of manufacturing the same**
Supraleitende Werkstoffe und Verfahren zu ihrer Herstellung
Matériaux supra-conducteurs et procédé pour leur fabrication

(30) Priority: 27.03.1987 JP 7520187
(43) Date of publication of application: 28.09.1988
(73) Proprietor: SEMICONDUCTOR ENERGY LABORATORY CO., LTD., Atsugi-shi Kanagawa-ken 243-0036 (JP)
(72) Inventor: Yamazaki, Shunpei, Setagaya-ku Tokyo 157 (JP)
(74) Representative: Milhench, Howard Leslie

(56) References cited:
- Physics Today, April 1988, pages 21-25
- Physica C, Vol.195, R. Feduzi et al.: "The influence of carrier concentration on the superconductive properties of YBa2Cu3-xLIxO6.5+y-X/2, 1992, pages 177-183
- Bull Korean Chem. Soc., Vol.13, No.4, Nam Hwi Hur et al.: "Substitutional Effects of Na in the YBa2Cu3O7-y Oxide Superconductors", 1992, pages 425-428
- Physical Review Letters, Vol. 58, No. 9, 2 March 1987, pages 908-910
- World Congress of Superconductivity, Proceedings of the 3rd International Conference and Exhibition, 15-18 September 1992, Special Issue of the Journal Applied Superconductivity, pages 607-625
- Applied Physics Letters, vol. 51, No. 8, 24th August 1987, pages 622-624

## Description

The present invention relates to improved superconducting materials, and more particularly concerns superconducting materials wherein the temperature at which the electrical resistance becomes zero (referred to as Tco hereinafter) closely approaches room temperature.

Conventional superconducting materials have included metallic compositions including elements such as mercury and lead, alloys such as NbN, Nb₃Ge, Nb₃Ga, and three-element compounds such as Nb₃(Al_{0.8}Ge_{0.2}). However, for such conventional materials the superconducting critical temperature (referred to as Tc hereinafter) at which the onset of superconductivity occurs is as low as 25°K.

In recent years, superconducting ceramic materials have been attracting a lot of attention. The Zurich Research Laboratory of IBM first reported such materials in the form of Ba-La-Cu-O (Balacuo) high-temperature oxide superconductors. In addition, cupric oxide-lanthanum-strontium (LSCO) type superconductors are also known. These materials are known. These materials are known in the form (A₁₋ ₓBₓ)_{y}CuO_{z}, where x=0.01 to 0.3, y=1.3 to 2.2, z=2.0 to 4.0. However, the Tc onset, that is the temperature at which superconductivity begins for this material is no more than 30°K.

It is possible that the superconductivity of these oxide ceramic materials derives from their Perovskite type structure. Hitherto no consideration has been given to the effect of impurities, with the attitude adopted being that it is adequate if the starting raw materials are 99% pure. For this reason, absolutely no consideration has been given to the effect of impurities, especially alkali metal elements, halogen elements, nitrogen and carbon, which may be present in the synthesized superconducting material.

The inventor of the present invention has discovered, during efforts to improve the Tco and Tc of superconducting ceramic materials, that these impurities collect at the boundaries of the ceramic particles and act as a barrier between the particles to which they adhere, so that they interfere with the electrical conductivity. In such conditions, it is not possible to increase the current density, and the Tco is lower than expected. Therefore, in order to increase the Tco, preferably to the temperature of liquid nitrogen (77°K) or greater, the present invention proposes to utilise materials of high purity in the fabrication of superconducting compositions and to process such material in such a manner as to reduce their impurity concentrations. As will be described hereinafter, the invention enables the production of superconducting materials which exhibit superconductivity at high temperatures so that the Tc onset occurs between 80°K and 124°K. More particularly, the present invention enables the production of a superconducting composition which has a critical temperature Tco of 77°K or greater and comprises a copper oxide superconducting material incorporating no more than 0.2% by weight of alkali metal impurities such as Li(lithium), Na(sodium), or K(potassium). The superconducting composition preferably incorporates no more than about 0.1% by weight of C(carbon) and/or N(nitrogen) impurity, and also preferably incorporates no more than about 0.1% by weight of a halogen element impurity.

According to the present invention there is provided a process for producing a copper oxide superconducting material having a critical temperature Tco of 77°K or greater, said process comprising selecting raw materials of a purity of 99.99% or higher for forming said copper oxide superconducting material, washing said materials in very high purity water, and thereafter processing the washed materials to form the copper oxide superconducting material under conditions such as to limit contamination thereof with alkali metal impurities to no more than 0.2% by weight.

Other features of the present invention are set forth in the appended claims and together with the above aspects will become apparent from consideration of the following description of exemplary embodiments given in conjunction with the accompanying drawing in which:

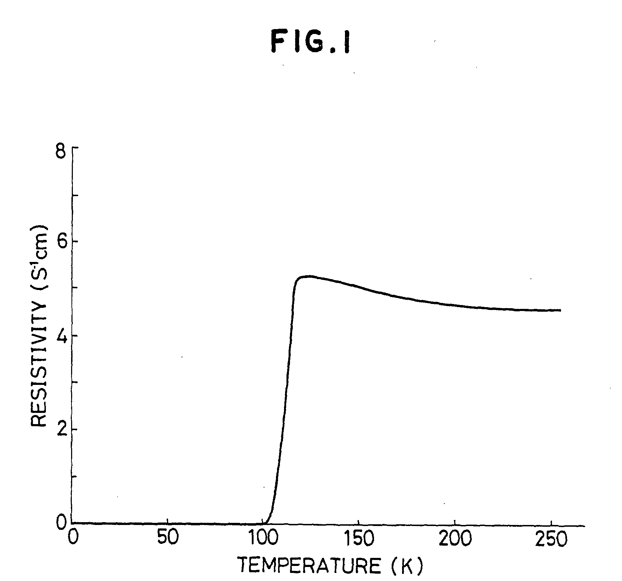

Fig. 1 is a graph showing the characteristics of an exemplary superconducting material made in accordance with the present invention.

For the avoidance of doubt it is to be noted that all references herein and in the appended claims to the Periodic Table and to specific Groups of the Periodic Table are to be understood to refer to the Japanese Periodic Table and to the Groups thereof as described in the Iwanami "Physics and Chemistry Dictionary". As compared with the Group designations of the Periodic Table as described in "The Penguin Dictionary of Science" for example, which are the Group designations commonly accepted throughout Europe, Groups Ia, IIa, VIII, Ib, IIb and 0 are the same in the Japanese and European Periodic Tables, Groups IIIa, IVa, Va, VIa and VIIa of the Japanese Periodic Table correspond respectively to Groups IIIb, IVb, Vb, VIb and VIIb of the European Periodic Table, and Groups IIIb, IVb, Vb, VIb and VIIb of the Japanese Periodic Table correspond respectively to Groups IIIa,, IVa, Va, VIa and VIIa of the European Periodic Table.

To satisfy the objects of the present invention, a ceramic superconducting material is made which essentially consists of copper, oxygen and at least one element selected from the Groups IIa and IIIa of the Japanese Periodic Table. One example of such a ceramic superconducting material is represented by the formula (A₁₋ₓBₓ)_{y}Cu_{z}O_{w}, where 0<x<1, y=2.0 to 4.0 and preferably 2.5 to 3.5, z=1.0 to 4.0 and preferably 1.5 to 3.5, and w=4.0 to 10.0 and preferably 6 to 8, A is an element selected from the yttrium group and other lanthanides, the yttrium group being as defined in "Physics and Chemistry Dictionary" (published April 1, 1963, Iwanami Shoten) as the group which includes Y(yttrium), Gd(gadolinium), Yb(ytterbium), Eu(europium), Tb(terbium), Dy(dysprosium), Ho(holnium), Er(erbium), Tm(thulium), Lu(lutetium), Sc(scandium), and other lanthanides, and B is at least one element selected from the group comprising Ra(radium), Ba(barium), Sr(strontium), Ca(calcium), Mg(magnesium), and Be(beryllium).

The composition of the present invention contains copper in a layered configuration, with one layer within one molecule, or in a symmetric two-layer structure, and is based on a model in which superconductivity is obtained from the orbit of the furthest exterior nucleus electron.

In the practice of the invention, raw materials of 99.99%(4N) purity or higher are used as starting materials rather than the conventionally-used 99(2N) to 99.95% purity. Then, an oxygen atmosphere of a purity in excess of 4N is used rather than air for oxidation, and the material is fired in 5N oxygen and 5N argon, or under vacuum for reduction. In this way, in a polycrystalline ceramic material, the crystalline grain size can be made larger, and in turn, a structure can be obtained in which the barriers at the crystal boundaries can be caused to substantially disappear. As a result, an even higher Tco is obtained. In this case, ideally there would be a single crystalline structure in the nucleus with no defects.

In the practice of the present invention, oxide or carbonate starting materials may be mixed, compressed or compacted once, and formed into an (A₁₋ ₓBₓ)_{y}Cu_{z}O_{w} type of material which is then ground to form a fine powder, once again compressed or compacted into tablet form, and fired. This superconducting ceramic material can be formed by an extremely simple process in which oxide or carbonate materials of 5N or 6N purity are used as the starting materials. The respective values for x, y, z, and w in the expression (A₁₋ₓBₓ)_{y}Cu_{z}O_{w} can be optionally varied and controlled stoichiometrically. The following examples serve to illustrate and explain the invention.

### Example 1

In Example 1 of the present invention, Y was used as A and Ba as B in the general expression (A₁₋ ₓBₓ)_{y}Cu_{z}O_{w}.

As starting materials, yttrium oxide (Y₂O₃) was used as the yttrium compound, barium carbonate (BaCO₃) as the barium compound, and copper oxide (CuO) as the copper compound. These were used in the form of fine powders with a purity of 99.99% or higher. The proportions were selected, so that x=0.33 (A:B=2:1), y=3, z=3, and w=6 to 8. As an alternative possibility half of the Ba could be replaced by Ca in the form of CaCO₃.

These materials were thoroughly blended in a mortar, washed well with highly purified water (specific resistance 18M ohms or greater) using an ultrasonic treatment, and then dried. In this way, alkali metal elements such as Li(lithium), Na(sodium), or K(potassium) and the like could be adequately washed out in this process. It was therefore possible to reduce the concentration of impurities throughout the finished material to 0.2% by weight, or preferably 0.005% by weight or less. This blended powder was then inserted into a capsule and formed into tablets (10mm diameter x 3mm) at a load of 30kg/cm². The tablets were then heated and oxidized in an oxidizing atmosphere, for example, in air at 500°C to 1000°C, and, for example, 700°C for 8 hours.

This process is referred to as the pre-firing process.

Next, this material was ground and blended in a mortar to an average particle radius of 10µm or less.

This blended powder was sealingly inserted into a capsule and formed into tablets by compressing at a load of 50kg/cm². The methods may also be adopted in a hot press system where the tablet is heated while it is being pressed, or in which an electric current is applied to the tablet, so that a light electric current flows through the tablet while the tablet is being heated.

Next, an oxidizing process was performed at between 500°C and 1000°C, for example at 900°C, in an oxidizing atmosphere such as an atmosphere of highly purified oxygen, and full firing was carried out for 10 to 50 hours, for example, 15 hours.

Then this sample material was heated in a low oxygen O₂-Ar mixture (with other impurities at 10 ppm or less) for 3 to 30 hours at 600°C to 1100°C, for example, and for 20 hours at 800°C, for reduction, resulting in a new structure which was observed clearly.

Using this sample material, the relationship between the specific resistance and temperature was determined. The highest temperature obtained for the Tc onset was observed to the 114°K, while the Tco was observed to be 103°K. The amounts of impurities present were measured by means of a Secondary Ion Mass Spectrometer (SIMS). The amounts of nitrogen and carbon dioxide were 0.1% or less by weight, and were specifically measured at only 0.01% by weight. The halogen elements detected were 0.1% or less by weight, and were specifically detected at only 0.001% by weight. The alkali metal elements were 0.2% or less by weight, and were specifically detected at only 0.001% by weight.

FIG.1 shows the temperature versus specific resistance characteristics of the superconducting material of the present invention which was obtained by virtue of this example.

### Example 2

In Example 2 of the present invention, Yb was blended as the oxide compound. Ba or a mixture of Ba and Sr in a 1:1 ratio was used as B. As starting materials, ytterbium oxide and yttrium oxide were used. Barium carbonate (BaCO₃) was used as the barium compound, and where Sr was used Sr₂O₃ was used as the strontium compound. Also, CuO was used as the copper compound. In all other respects this example was the same as the first example.

The Tc onset obtained was 119°K, and the Tco obtained was 107°K in this example.

### Example 3

This example was made on the basis of a conventional method for the purpose of comparison.

As in Example 1, the starting materials were 4N in purity. The material was blended in the form of fine powders, but only simple washing with city water was performed rather than ultrasonic washing with highly purified water. Other manufacturing conditions remained the same as for Example 1. The Tc in this case was only 92°K and Tco only 74°K. The results of analyses for impurities conducted on the resulting tablets gave 0.3% by weight for sodium in the alkali metal elements, and 0.5% by weight for carbon and nitrogen.

### Example 4

Similar processes as in Example 1 were carried out except that other materials such as magnesium (Mg) and beryllium (Be) were used as B. The result obtained was substantially the same as in the first example.

In the present invention, the respective starting material compounds are substantially the same as the final compound, specifically the compounds including the materials indicated by the expression (A₁₋ ₓBₓ)_{y}Cu_{z}O_{w} as a result of finely grinding the material after pre-firing. Further, a plurality of elements from Groups IIa and IIIa of the Japanese Periodic Table are blended together in these end material compounds because the copper is more easily obtained in a layered configuration within the molecular structure. In this way, the impurities which tend to segregate at the particle boundaries of the final compound are removed. In other materials, the respective particles tend to more easily fuse with the adjacent particles. Observation with an electron microscope (x40,000) shows that the spherical and granular particles are more loosely packed together in the third example above described, whereas in the first example of the present invention as above described, there is a considerably higher degree of denseness in the packing and the respective polycrystalline particles are clearly seen to be mutually adhering in a face to face relationship. Specifically, the Tc onset and Tco can be presumed to be at a higher temperature in the present invention because impurities such as the alkali metal elements, halogen elements, carbon and nitrogen have been removed.

Also, the mechanism of the superconductivity of the superconducting ceramic materials which exhibit the molecular structure of the present invention is presumed to be related to the fact that the copper oxide material has a laminar structure, and this laminar structure has one layer or two layers in one molecule. The superconductivity is obtained through carriers within this layer. If the contact area at the boundaries of the layers and the adjacent particles within the molecule is small, an extremely large obstacle is presented increasing the maximum current flow and thereby increasing Tco. The present invention has succeeded for the first time in the world in enlarging the mutual surfaces of the particles and obtaining intimate contact between them by eliminating or reducing the incidence of impurities such as alkali metal elements, halogen elements, carbon and nitrogen.

The embodiments of the present invention as described in the examples are made in tablet form. However, it is possible to prepare a thin film superconducting ceramic material by omitting the formation of a tablet and by dissolving or suspending the powder obtained after pre-firing or full firing in a solvent carrier, coating a substrate or the like with the resulting suspension and firing the coated substrate in an oxidizing atmosphere, followed by firing in a reducing atmosphere.

Superconducting ceramic materials in accordance with the present invention may also be prepared consistent with the stoichiometric formulae (A₁₋ ₓBₓ)_{y}Cu_{z}O_{w}, where A is one or more elements of Group IIIa of the Japanese Periodic Table, e.g., the rare earth elements, B is one or more elements of Group IIa of the Japanese Periodic Table, e.g., the alkaline earth metals including beryllium and magnesium, and 0<x<1; y=2.0 to 4.0, preferably 2.5 to 3.5; z=1.0 to 4.0, preferably 1.5 to 3.5; and w=4.0 to 10.0, preferably 6.0 to 8.0. Also, superconducting ceramics in accordance with the present invention may be prepared consistent with the stoichiometric formulae (A₁₋ₓBₓ)_{y}Cu_{z}O_{w}, where A is one or more elements of Group Vb of the Japanese Periodic Table such as Bi, Sb, and As. B is one or more elements of Group IIa of the Japanese Periodic Table, E.g., the alkaline earth metals including beryllium and magnesium, and x=0 to 1; y=2.0 to 4.0, preferably 2.5 to 3.5; z=1.0 to 4.0, preferably 1.5 to 3.5; and w=4.0 to 10.0, preferably 6.0 to 8.0. One example of the former formulae is YBa₂Cu₃Oₓ(x=6 to 8), and examples of the latter formulae are BiSrCaCu₂Oₓ and Bi₄Sr₃Ca₃Cu₄Oₓ. In addition, the composition Bi₄(Sr_{y}Ca₂)Cu₄Oₓ is possible for such purposes and its Tc is 40 to 60 when the value of y is about 1.5. The Tc onset and Tco of the composition Bi₄Sr₄Ca₂Cu₄Oₓ are 110°K and 79°K, respectively. The value of x in the above formulae is estimated to be 6 to 10, for example about 8.1.

The superconducting material can also be that generally represented as (A₁₋ₓBₓ)_{y}Cu_{z}O_{w} wherein 0<x<1; y=2.0 to 4.0; w=4.0 to 10.0; and A is at least one element selected from Ga, Zr, Nb and Ge, and B is at least one element selected from the alkaline earth metals. Specifically, desirable ranges are; x=0.1 to 1; y=2.5 to 3.5; z=1.5 to 3.5; w=7.0 to 8.0.

The stoichiometric formulae mentioned above can be determined for example by X-ray diffraction.

## Claims

1. A process for producing a copper oxide superconducting material having a critical temperature Tco of 77°K or greater, said process comprising selecting raw materials of a purity of 99.99% or higher for forming said copper oxide superconducting material, washing said materials in very high purity water, and thereafter processing the washed materials to form the copper oxide superconducting material under conditions such as to limit contamination thereof with alkali metal impurities to no more than 0.2% by weight.

2. The process of claim 1 wherein said raw materials comprise fine powders which are thoroughly blended and, after washing, the washed material is heated in an oxidizing atmosphere of high purity so as to oxidize the material, then the resulting material is subjected to grinding and blending, followed by heating in a low oxygen oxygen-argon atmosphere.

3. The process of claim 2, in which the pure water has a specific resistance of 18M Ohms or greater, the oxidizing atmosphere comprises at least 99.99% pure oxygen and the impurity concentration of the low oxygen oxygen-argon atmosphere is 10 ppm or less.

4. The process of any preceding claim wherein said alkali metal impurities comprise lithium, sodium and potassium.

5. The process of any preceding claim, wherein the superconducting material is a ceramic compound substantially consisting of copper, oxygen and at least one element selected from Groups IIa and IIIa of the Japanese Periodic Table.

6. The process of claim 5, wherein the superconducting material is generally represented as (A₁₋ₓBₓ)_{y}Cu_{z}O_{w}, where 0<x<1, y=2.0 to 4.0, z=1.0 to 4.0 and w=4.0 to 10.0; A is an element selected from the group comprising yttrium, gadolinium, ytterbium, europium, terbium, dysprosium, holmium, erbium, thulium, lutetium, scandium, and other lanthanides; and B is an element selected from among radium, barium, strontium, calcium, magnesium, and beryllium.

7. The process of any of claims 1 to 4 wherein the superconducting material is generally represented as (A₁₋ₓBₓ)_{y}Cu_{z}O_{w} wherein 0<x<1; y=2.0 to 4.0; z=1.0 to 4.0 and w=4.0 to 10.0; and A is at least one element selected from the group comprising Ga, Zr, Nb, and Ge, and B is at least one element selected from the group of alkaline earth metals.

8. The process of any of claims 1 to 4, wherein the superconducting material is generally represented as (A₁₋ₓBₓ)_{y}Cu_{z}O_{w}, where A is at least one element selected from group Vb of the Japanese Periodic Table, and B is at least one element selected from group Ha of the Japanese Periodic Table, and 0<x<1; y=2.0 to 4.0; z=1.0 to 4.0; and w=4.0 to 10.0.

9. The process of any preceding claim, wherein the process steps are effected so that the finished superconducting material incorporates no more than 0.1% by weight of carbon and/or nitrogen impurity.

10. The process of any preceding claim wherein the process steps are effected so that the finished superconducting material incorporates no more than 0.1% by weight of a halogen element impurity.

11. A superconducting composition formed by the process of any preceding claim.

## Patentansprüche

1. Verfahren zur Herstellung eines supraleitenden Kupferoxidmaterials mit einer kritischen Temperatur Tco von mindestens 77°K, wobei
Rohmaterialien mit einer Reinheit von mindestens 99,99% zum Bilden des supraleitenden Kupferoxidmaterials ausgewählt,
diese Materialien in Reinstwasser gewaschen, und
die gewaschenen Materialien anschließend zum Bilden des supraleitenden Kupferoxidmaterials unter Bedingungen verarbeitet werden, die deren Kontamination mit Alkalimetallverunreinigungen auf weniger als 0,2 Gew.-% begrenzen.

2. Verfahren nach Anspruch 1, wobei
die Rohmaterialien gründlich vermischte, feine Pulver umfassen,
das gewaschene Material nach dem Waschen in einer Oxidationsatmosphäre hoher Reinheit geheizt wird, so daß das Material oxidiert,
das sich ergebende Material anschließend zerkleinert und vermischt, und
in einer Sauerstoff/Argon-Atmosphäre mit geringem Sauerstoffanteil geheizt wird.

3. Verfahren nach Anspruch 2, in dem
das Reinwasser einen spezifischen Widerstand von mindestens 18 MΩ aufweist,
die Oxidationsatmosphäre wenigstens 99,99% reinen Sauerstoff enthält, und
die Verunreinigungskonzentration der Sauerstoff/Argon-Atmosphäre mit niedrigem Sauerstoffanteil höchstens 10 ppm beträgt.

4. Verfahren nach einem der vorstehenden Ansprüche, wobei die Alkalimetallverunreinigungen Lithium, Natrium und Kalium umfassen.

5. Verfahren nach einem der vorstehenden Ansprüche, wobei das supraleitende Material einen Keramikverbund darstellt, der im wesentlichen aus Kupfer, Sauerstoff und wenigstens einem Element aus den Gruppen IIa und IIIa des japanischen Periodensystems besteht.

6. Verfahren nach Anspruch 5, wobei das supraleitende Material allgemein durch (A₁₋ₓBₓ)_{y}Cu_{z}O_{w} gegeben ist, wobei
0<x<1, y=2,0 bis 4,0, z=1, 0 bis 4,0 und w=4,0 bis 10,0;
A ein Element aus der Gruppe Yttrium, Gadolinium, Ytterbium, Europium, Terbium, Dysprosium, Holmium, Erbium, Thulium, Lutetium, Scandium und anderer Lanthanoide; und
B ein Element aus der Gruppe Radium, Barium, Strontium, Kalzium, Magnesium und Beryllium darstellt.

7. Verfahren nach einem der Ansprüche 1 bis 4, wobei das supraleitende Material allgemein durch (A₁₋ₓBₓ)_{y}Cu_{z}O_{w} gegeben ist, wobei
0<x<1, y=2,0 bis 4,0, z=1,0 bis 4,0 und w=4,0 bis 10,0;
A wenigstens ein Element aus der Gruppe Ga, Zr, Nb und Ge darstellt; und
B wenigstens ein Element aus der Gruppe der alkalischen Erdmetalle darstellt.

8. Verfahren nach einem der Ansprüche 1 bis 4, wobei das supraleitende Material allgemein durch (A₁₋ₓBₓ)_{y}Cu_{z}O_{w} gegeben ist, wobei
A wenigstens ein Element aus der Gruppe Vb des japanischen Periodensystems;
B wenigstens ein Element aus der Gruppe IIa des japanischen Periodensystems darstellt; und
0<x<1, y=2,0 bis 4,0, z=1,0 bis 4,0, und w=4,0 bis 10,0 gilt.

9. Verfahren nach einem der vorstehenden Ansprüche, wobei die Verfahrensschritte so bewirkt werden, daß das fertiggestellte, supraleitende Material nicht mehr als 0,1 Gew.-% Kohlenstoff und/oder Stickstoff-Verunreinigung enthält.

10. Verfahren nach einem der vorstehenden Ansprüche, wobei die Verfahrensschritte so bewirkt werden, daß das fertiggestellte, supraleitende Material nicht mehr als 0,1 Gew.-% Verunreinigung an Halogenelementen enthält.

11. Nach einem Verfahren der vorstehenden Ansprüche gebildete supraleitende Zusammensetzung.

## Revendications

1. Procédé pour produire un matériau supraconducteur à base d'oxyde de cuivre ayant une température critique Tco de 77 K ou plus, ledit procédé comprenant la sélection de matières premières ayant une pureté de 99,99 % ou plus pour former ledit matériau supraconducteur à base d'oxyde de cuivre, le lavage desdits matériaux avec de l'eau très pure, et ensuite le traitement des matériaux lavés pour former le matériau supraconducteur à base d'oxyde de cuivre dans des conditions limitant leur contamination avec des impuretés de type métal alcalin à pas plus de 0,2 % en poids.

2. Procédé selon la revendication 1, dans lequel lesdites matières premières comprennent des poudres fines qui sont soigneusement mélangées et, après lavage, le matériau lavé est chauffé dans une atmosphère oxydante de haute pureté de façon à oxyder le matériau, puis le matériau résultant est soumis à un broyage et à un mélange, suivis d'un chauffage dans une atmosphère d'oxygène/argon à faible teneur en oxygène.

3. Procédé selon la revendication 2, dans lequel l'eau pure a une résistance spécifique de 18 Mohms ou plus, l'atmosphère oxydante comprend de l'oxygène pur à 99,99 % au poins et la concentration d'impuretés dans l'atmosphère d'oxygène/argon à faible teneur en oxygène est de 10 ppm ou moins.

4. Procédé selon l'une quelconque des revendications précédentes, dans lequel lesdites impuretés de type métal alcalin comprennent du lithium, du sodium et du potassium.

5. Procédé selon l'une quelconque des revendications précédentes, dans lequel le matériau supraconducteur est un composé céramique constitué essentiellement de cuivre, d'oxygène et d'au moins un élément choisi dans les Groupes IIa et IIIa du Tableau Périodique Japonais.

6. Procédé selon la revendication 5, dans lequel le matériau supraconducteur est généralement représenté par (A₁₋ₓBₓ)_{y}Cu_{z}O_{w}, où 0 < x < 1, y = 2,0 à 4,0, z = 1,0 à 4,0 et w = 4,0 à 10,0 ; A est un élément choisi dans l'ensemble constitué par l'yttrium, le gadolinium, l'ytterbium, l'europium, le terbium, le dysprosium, le holmium, l'erbium, le thulium, le lutétium, le scandium, et d'autres lanthanides ; et B est un élément choisi parmi le radium, le baryum, le strontium, le calcium, le magnésium et le béryllium.

7. Procédé selon l'une quelconque des revendications 1 à 4, dans lequel le matériau supraconducteur est généralement représenté par (A₁₋ₓBₓ)_{y}Cu_{z}O_{w} où 0 < x < 1 ; y = 2, 0 à 4, 0 ; z = 1, 0 à 4, 0 et w = 4, 0 à 10, 0 ; et A est au moins un élément choisi dans l'ensemble constitué par Ga, Zr, Nb et Ge, et B est au moins un élément choisi dans le groupe des métaux alcalino-terreux.

8. Procédé selon l'une quelconque des revendications 1 à 4, dans lequel le matériau supraconducteur est généralement représenté par (A₁₋ₓBₓ)_{y}Cu_{z}O_{w}, où A est au moins un élément choisi dans le groupe Vb du Tableau Périodique Japonais, et B est au moins un élément choisi dans le groupe IIa du Tableau Périodique Japonais, et 0 < x < 1 ; y = 2,0 à 4,0 ; z = 1,0 à 4,0 ; et w = 4,0 à 10,0.

9. Procédé selon l'une quelconque des revendications précédentes, dont les étapes sont effectuées de façon que le matériau supraconducteur fini ne comprenne pas plus de 0,1 % en poids d'impuretés carbone et/ou azote.

10. Procédé selon l'une quelconque des revendications précédentes, dont les étapes de traitement sont effectuées de façon que le matériau supraconducteur fini ne comprenne pas plus de 0,1 % en poids d'impuretés de type halogène élémentaire.

11. Composition supraconductrice produite par le procédé selon l'une quelconque des revendications précédentes.
